# EUROPEAN PATENT APPLICATION

(11) **EP 4 739 066 A1**
(43) Date of publication of application: **06.05.2026**
(21) Application number: 25211957.3
(22) Date of filing: 29.10.2025
(51) Int. Cl.: H10W 40/73, H10W 70/40, F28D 15/04

(54) **A SEMICONDUCTOR DEVICE**

(30) Priority: 29.10.2024 NL 2038949
(71) Applicant: Nexperia B.V., 6534 AB Nijmegen (NL)
(72) Inventor: Gong, Wei, Manchester (GB); Cao, Pulong, Shanghai (CN); Liu, Hui, Shanghai (CN)
(74) Representative: Pjanovic, Ilija

(57) **Abstract**

A semiconductor device is proposed, comprising a substrate, at least a first semiconductor die having a first die surface and a second die surface opposite to the first die surface, wherein the at least one semiconductor die is mounted with the first die surface on the substrate, and at least one heat transfer component comprising a spatial configuration composed of a first component face and a second component face spaced apart from each other defining a spatial enclosure comprising a heat transfer medium, wherein the at least one heat transfer component is in heat exchanging contact with the second die surface and the substrate.

## Description

### TECHNICAL FIELD

The present disclosure relates to a semiconductor with improved thermal management.

### BACKGROUND OF THE DISCLOSURE

Semiconductor devices are essential building blocks of modern electronics. While they offer incredible computational power or current control, they also generate significant amounts of heat. This heat can have significant consequences on the semiconductor device's reliability or performance.

This heating effect is commonly known as resistive heating or Joule heating and is especially bad in semiconductor devices operating at high voltages, large current, or at high switching frequencies.

The excessive heat can lead to degradation of the semiconductor device, thereby accelerating its aging and reducing its lifetime. In some cases, the heat can be so excessive that the device's noise increases or even that the materials start to degrade, resulting in catastrophic device failure.

Accordingly, it is a goal of the present disclosure to provide an improved semiconductor package, which has an improved thermal management.

### SUMMARY OF THE DISCLOSURE

The disclosure pertains to a semiconductor device comprising a substrate, at least a first semiconductor die having a first die surface and a second die surface opposite to the first die surface, wherein the at least one semiconductor die is mounted with the first die surface on the substrate, and at least one heat transfer component comprising a spatial configuration composed of a first component face 310 and a second component face 320 spaced apart from each other defining a spatial enclosure 350 comprising a heat transfer medium 390, wherein the at least one heat transfer component is in heat exchanging contact with the second die surface and the substrate.

A semiconductor according to the disclosure is not only able to transfer current to the semiconductor die by means of the heat transfer component, but can also effectively transfer the heat away from the semiconductor die. Thereby, the semiconductor has an improved thermal management, but does not become bulky with additional heatsink or cooling elements, such that the overall size of the semiconductor die can be maintained.

In the view of the current patent application, the wording "mounted" should thus be considered to define "being connected by some means", for instance by heat and/or electrically conductive glue or solder, but even by means of a heat transfer component, which in turn may be directing connected or could be connected by conductive glue or solder.

A heat transfer component as defined by the disclosure may also been known in the art as vapor chambers. These elements are two-phase heat transfer devices that efficiently spread heat across a large, flat surface. Typically, they comprise two planar plates sealed around the edges filled with a heat transfer medium 390. The heat transfer component absorbs heat from the semiconductor die causing a portion of the first component face 310 to heat up. The heat transfer medium 390, in liquid state, on the inside of the spatial enclosure 350 at the first component face 310 side will then also heat up and evaporate. Subsequently, the vapors travels through the heat transfer component's enclosure to a cooler portion. There the vapors of the heat transfer medium 390 condensate releasing the absorbed heat, turning back into a liquid state, which liquid is directed back to the hot portion 330 of the heat transfer component. This process is a continuous, self-contained cycle, which efficiently moves heat from one portion of the heat transfer component to another.

With the use of such a heat transfer component, the semiconductor device can manage its heat more effectively, such that the semiconductor die does not overheat, causing unwanted effect, like malfunctioning or even breakage. Furthermore, this allows for more efficient use of the entire semiconductor device's size to be coupled to even further heat sinks and such in the application that the semiconductor device may be utilized.

To ensure that the size or bulkiness of the semiconductor device does not increase because of this improved heat management with a heat transfer component, the solution is to utilize the electric conductive properties of the heat transfer component as well. This way, both electricity and heat can be conducted, requiring minimal adjustment to the overall design of the semiconductor device, yet having maximum impact.

Lastly, positioning an electrical and heat conductive heat transfer component on top of a semiconductor die, being connected to the substrate as well, ensures that the heat transfer component can act as a bond clip even improved thermal performance over standardized bond clips, but also allowing for higher current carrying capacity due to the increased (contact)size, and furthermore, the parasitic inductance may be removed. This all leads to improved reliability of the semiconductor device.

In an example, the semiconductor device further comprises a further heat transfer component, wherein the further heat transfer component is arranged between the substrate and the first die surface of at least one semiconductor die, being in heat exchanging contact as well as electrical contact. It may be understood that the further heat transfer component is supported by the substrate and in turn supports the at least one semiconductor die.

Providing the semiconductor device with a further heat transfer component allows to transport heat away from the semiconductor die from both sides thereof. In other words, the further heat transfer component allows both heat and current to be communicated between the substrate and the first die surface. This basically doubles the heat management and especially ensures that the semiconductor die does not overheat. Again, similar to the first heat transfer component this one is made of a heat dissipating and electrically conductive material comprising a spatial enclosure 350 filled with a heat transfer medium 390. Having a further heat transfer component underneath the at least one semiconductor die allows for dissipating heat from the at least one semiconductor die towards the substrate of the semiconductor device, which typically acts as the general heatsink of semiconductor devices.

In a continuing example, the semiconductor device further comprises at least one further semiconductor die, wherein the further heat transfer component is in heat exchanging contact with the second die surface of the at least further semiconductor die.

In some cases, the semiconductor device may be equipped with more than one semiconductor die. It could then even be conceivable that one terminal of a semiconductor die may be connected directly to another terminal of a further semiconductor die. In this example, the bottom terminal of the at least one semiconductor die is directly connected to the top terminal of an at least one further semiconductor die. This way the heat from the at least one semiconductor die's first die surface is dissipated towards the substrate and at the same the heat from the at least one further semiconductor die's second die surface is dissipated to the substrate. Furthermore, this connection allows for current to flow from the at least one semiconductor die's first die surface to the at least one further semiconductor die's second die surface or vice versa without needing additional connecting means, like bond wires 400 or bond clips.

It should be understood that the wording "at least a semiconductor die" may be considered to comprise a plurality of semiconductor dies. For instance, in some semiconductor devices it may be needed to have several semiconductor dies operate in parallel. The same holds for the wording "at least a further semiconductor die", which could thus also comprise a plurality of semiconductor dies.

In another example of the semiconductor device according to disclosure, each heat transfer component further comprises a porous condensing structure 360 contained in the spatial enclosure 350 for the heat exchanging medium.

In a specific example thereof, the porous condensing structure 360 is mounted to the first component face 310.

Having a porous condensing structure 360, also known in the art as a wick, contained in the spatial enclosure 350 ensures that the condensing heat transfer medium 390 liquids are drawn back towards the hot portion 330 of the heat transfer component. Utilizing a porous condensing structure 360 ensures that capillary action drives the cold liquid heat transfer medium 390 towards the portion where the porous condensing structure 360 is empty, which is the hot portion 330 of the heat transfer component. The actual size of the pores as well as the porosity depends on the heat transfer medium 390 that is being used, but it can be understood that these are chosen such that the heat transfer properties of the heat transfer component are greater than without the presence of a porous condensing structure 360.

When the porous condensing structure 360 is mounted to the first component face 310 on the spatial enclosure 350 side, it may be understood that the outer side of the first component face 310 is the part of the heat transfer component that is being connected to the second die surface of the at least one semiconductor die. This way, the heat can be dissipated more effectively, since there is less material that needs to be heated up to reach the liquid heat transfer medium 390. Please note, however, that even when the first component face 310 is not directly connected to the semiconductor die, the heat transfer properties of the heat transfer component are still excellent. Overtime, especially going towards a steady-state, there will be no to only little difference between the two.

In a further example of the disclosure, each heat transfer component is made of a heat conductive and electrically conductive material.

In other to have the desired properties of conducting both heat and current a metal may be chosen, much like copper, gold, silver, aluminum, brass, steel, graphite, or silicon carbide. However, any material having both of these properties is suitable and the previous list should not be considered limiting.

In yet another example, each heat transfer component has a planar shape, wherein a thickness of the planar shape is less than 0.5 mm, preferably less than 0.33mm, most preferably less than 0.21mm.

A planer shape is beneficial since is allows to keep the overall thickness of the semiconductor device to remain small. Furthermore, most semiconductor devices are wider than they are thick or tall. The thickness of a planar shape, would be its nominal thickness, being in its planar configuration. However, the shape of the heat transfer component is not limited thereto. It is meant that this shape can still have a three dimensional structure containing bumps curves or elevation. However, its general thickness along those features remains approximately the same thickness. For instance, a picture of such a shape that may be drawn in one's mind could be an arced bridge having the same thickness along its length. However, there still may be some substantial height to the bridge to allow underpassage thereof.

In a last example according to the disclosure, each heat transfer component face has a thickness of less than 100 µm, preferably less than less than 50 µm, more preferably less than 10 µm.

Having these dimensions for the heat transfer component's faces allows for faster heat transfer towards the heat transfer medium 390. The expert in the field will understand that material of such dimensions typically become flexible and that the spatial enclosure 350 in such cases may collapse due to the capillary forces of the heat transfer medium 390. Therefore, the spatial enclosure 350 of the heat transfer component may even comprise small pillar 370 arranges throughout reaching from the first component face 310 to the second component face 320, such that a collapse may not occur, which would be detrimental to the heat transfer properties of the heat transfer component.

All in all, these examples provide in a semiconductor device which has improved heat management and allows for effective current transfer without increasing the bulkiness or size of the semiconductor device in general.

### BRIEF DESCRIPTION OF THE DRAWINGS

The disclosure will now be discussed with reference to the drawings, which show in:
Figure 1 shows the basis principle of a heat transfer component.
Figures 2A-D show various configurations of heat transfer components.
Figures 3A-B show a top and side view, respectively, of the heat transfer components in a semiconductor device.
Figures 4A-C show yet other configurations of heat transfer components.
Figures 5 show a top view of the heat transfer components in a semiconductor device.
Figure 6 shows a cross-sectional side view of the heat transfer components in a semiconductor device.

### DETAILED DESCRIPTION OF THE DISCLOSURE

For a proper understanding of the disclosure, in the detailed description below corresponding elements or parts of the disclosure will be denoted with identical reference numerals in the drawings.

The examples given in the figures are to be understood to explain the general concept of the present disclosure. The specific configurations of the heat transfer components 300 and the corresponding semiconductor devices may vary depending on the actual implementation and requirements of the semiconductor device. Nevertheless, the principles shown in the figures will be understood by the expert in the field to be transferable.

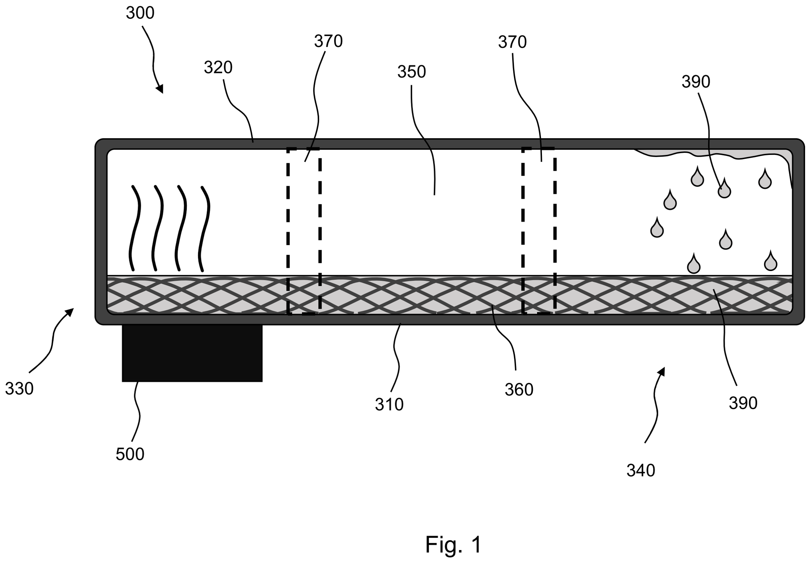

Figure 1 depicts a cross-section of a heat transfer component 300 according to the disclosure. Such a heat transfer component 300 may also be known in the art as a vapor chamber. The heat transfer component 300 comprises a spatial configuration composed of a first component face 310 and a second component face 320 spaced apart from each other defining a spatial enclosure 350 comprising a heat transfer medium 390, wherein the at least one heat transfer component 300 is in heat exchanging contact with a heat source 500. The heat transfer component 300 is a two-phase heat transfer devices that efficiently transfer heat from a first portion 330 towards a second portion 340. Typically, the two component faces are shaped as two planar plates, which are sealed together at their edges.

In Figure 1, this sealing is shown to result in the heat transfer component 300 having two vertical platelike edges, however this is a mere example. For instance, the two component faces may also be pinched at their edges such that an elongated hexagonal cross-section of the heat transfer component 300 is obtained, much like the shape of a sealed candy wrapper.

The heat transfer component 300 is able to transport/transfer the absorbed heat from a heat source 500 on the first component face 310, as shown in Fig. 1, creating a hot portion 330 of the heat transfer component 300 to a cold portion. It does this by absorbing the heat from the heat source 500 causing a portion of the first component face 310 to heat up. Then the heat transfer medium 390, in liquid state, on the inside of the spatial enclosure 350 at the first component face 310 side will also heat up and evaporate. Subsequently, the vapors travels through the heat transfer component's 300 spatial enclosure 350 to a cooler portion. There the vapors of the heat transfer medium 390 condensate releasing the absorbed heat, turning back into a liquid state, which liquid is directed back to the hot portion 330 of the heat transfer component 300. This process is a continuous, self-contained cycle, which efficiently moves heat from the hot portion 330 of the heat transfer component 300 to the cold portion. In Fig. 1 the hot portion 330 is shown on the left side of the heat transfer component 300 and the cold portion on the right side of the heat transfer component 300.

To improve the heat transfer property of the heat transfer component 300, the heat transfer component 300 of Fig. 1 further comprises a porous condensing structure 360 contained in the spatial enclosure 350 for the heat exchanging medium, in particular being mounted to the first component face 310.

The porous condensing structure 360, also known as a wick, ensures that the condensing heat transfer medium 390 liquid is transported towards the hot portion 330 of the heat transfer component 300 due to capillary action. Namely, the capillary action of porous condensing structure 360 is driven by the fact that the cold portion has excess liquid heat transfer medium 390 in the porous condensing structure 360 and the hot portion 330 is little to no liquid heat transfer medium 390 in its porous condensing structure 360 due to the initial evaporation of the heat transfer medium 390. It should be understood by the expert in the field that the actual size of the pores as well as the porosity depend on the properties of the heat transfer medium 390 that is being used.

When the porous condensing structure 360 is mounted to the first component face 310 on the spatial enclosure 350 side where the heat source 500 is located, it may be understood that heat can be dissipated more effectively, since there is less material that needs to be heated up to reach the liquid heat transfer medium 390. However, this is not necessary for the functioning of the heat transfer component 300. Even when a heat source 500 is connected to the second component face 320 where the porous condensing structure 360 is not located, the heat transfer properties of the heat transfer component 300 are still superior over solid and monoblock heat transfer components. Especially when a steady-state for the heat transfer has been obtained, there will be no to only little difference between whether the porous condensing structure 360 is located on the component face directly or not directly mounted to a heat source 500. The example as shown in Fig. 1 of having the porous condensing structure 360 located on the component face that is mounted to a heat source 500 may be mostly beneficial when heat pulses of heat source 500 are to be expected.

Thus far, the heat transfer properties of the heat transfer component 300 have been mostly highlighted. However, the heat transfer component 300 according to the disclosure is set apart by not only transferring heat, but also current. Therefore, the heat transfer component 300 is made of a thermally conductive and electrically conductive material. Such a material may be a metal, much like copper, gold, silver, aluminum, brass, steel, graphite, or silicon carbide. However, any material having both thermally and electrically conductive properties is suitable and the previous list should thus not be considered limiting, but mere indicative.

In order to properly utilize such heat transfer components 300 as proposed/indicated in this disclosure, the heat transfer component 300 preferably has a planar shape, wherein a thickness of the planar shape is less than 0.5 mm, preferably less than 0.33mm, most preferably less than 0.21mm. Furthermore, each component face has a thickness of less than 100 µm, preferably less than less than 50 µm, more preferably less than 10 µm.

Having these dimensions allow the heat transfer component 300 to be easily utilized in existing semiconductor device 1000 layouts, since no to little adjustment needs to be made to improve the thermal management. Furthermore, such dimensions, especially for the component's face allows for faster heat transfer towards the heat transfer medium 390.

The heat transfer component 300 of Fig. 1 further shows to comprise pillars 370. These are meant to maintain structural integrity of the heat transfer component 300. Namely, it may be understood that material of such dimensions typically becomes flexible and that the spatial enclosure 350 in such cases could collapse due to the capillary forces of the heat transfer medium 390. These pillars 370 are then arranged reaching from the first component face 310 to the second component face 320, such that a collapse of the spatial enclosure 350 may not occur.

With the use of a heat transfer component 300 that can both transfer heat and conduct current, the semiconductor device 1000 can manage its heat more effectively without needing additional elements. Thereby, the overall size and dimensions of the semiconductor device 1000 can be kept small compared to alternative semiconductor devices, which rely on big heat sinks etc. Furthermore, when the semiconductor die 200 does not overheat, no unwanted effect, like malfunctioning or even breakage are to be expected anymore.

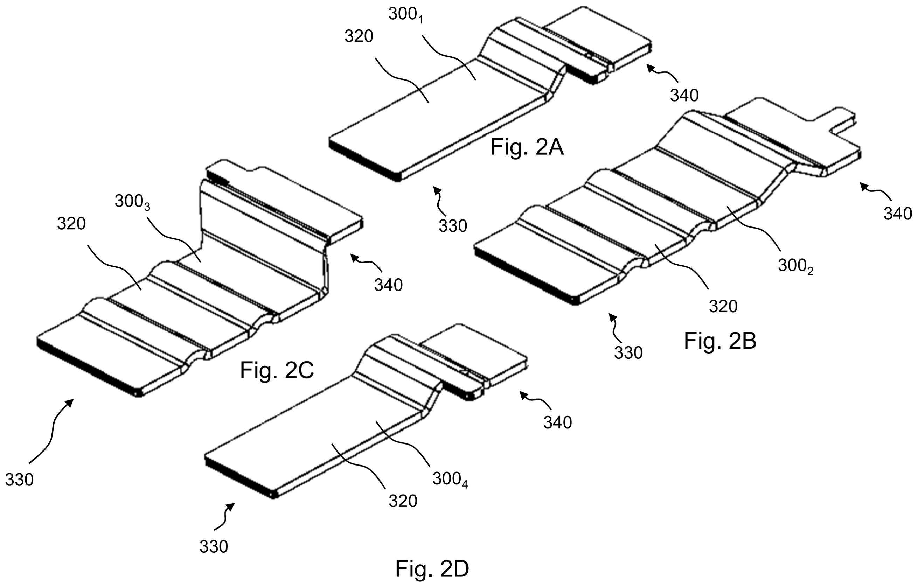

Figs. 2A-2D show some examples of heat transfer components 300₁, 300₂, 300₃, and 300₄ according to the disclosure. All four heat transfer components 300₁, 300₂, 300₃, and 300₄ of Figs. 2A-D are intended to be in heat exchanging contact with a heat source 500 and a heat drain via its first component face 310. This component face 310 is shown in the figures to be on the bottom side. For instance, the heat transfer components as shown may be positioned on top of a semiconductor die 200 with one portion 330 of the heat transfer component 300₁, 300₂, 300₃, and 300₄ and connecting to a substrate 100 with another portion 340 of the heat transfer component 300₁, 300₂, 300₃, and 300₄.

This way, heat can be transferred effectively from the semiconductor die 200 (heat source 500) towards the substrate 100 (heat drain). Yet additionally, current may be transferred from/to the semiconductor die 200 to/from the substrate 100, allowing the semiconductor device 1000 to fulfill its requirements without the need of additional elements, thereby maintaining or staying close to its original size. Furthermore, this allows to effectively drain heat from the top of a semiconductor die 200 on a semiconductor device, which would otherwise not be possible. In most semiconductor devices the second die surface 220 (top side) is left in contact with air or encapsulant, which then needs convection of the insulative air or conduction of the insulative encapsulant. Both present bad, inefficient paths for heat transfer.

In these examples, it may be understood that the position of the porous condensing structure 360 on the inside of the spatial enclosure 350 preferably is on the first component face 310's side.

Furthermore, in Figs 2A-2D the heat transfer components 300₁, 300₂, 300₃, and 300₄ are shown to have three dimensional structures, next to their planar configuration. It may be understood that for these heat transfer components 300₁, 300₂, 300₃, and 300₄ the thickness of the planar shape, being its nominal thickness is maintained over the entire element. However, its three dimensional shape is not limited to remaining planar, which means that the three dimensional shape may contain bumps, curves or elevations, wherein its nominal thickness remains approximately the same.

This three dimensional structure of the heat transfer component 300₁, 300₂, 300₃, and 300₄ has the advantage of allowing terminals to pass under the heat transfer component 300₁, 300₂, 300₃, and 300₄, without getting into electrical contact with the heat transfer component 300₁, 300₂, 300₃, and 300₄. Furthermore, it allows for elevating one portion of the heat transfer component 300₁, 300₂, 300₃, and 300₄ to the height of the second surface of a semiconductor die 200 while having the other portion at the height of the substrate 100, (the substrate 100 being at a lower height than the semiconductor die 200). Alternatively, it allows for directing the heat transfer component 300₁, 300₂, 300₃, and 300₄ in lateral direction, such that for instance other dies, terminals, electrical components, etc. can be avoided of contacting. This way, the heat and current can be transferred between preferred locations on the semiconductor device.

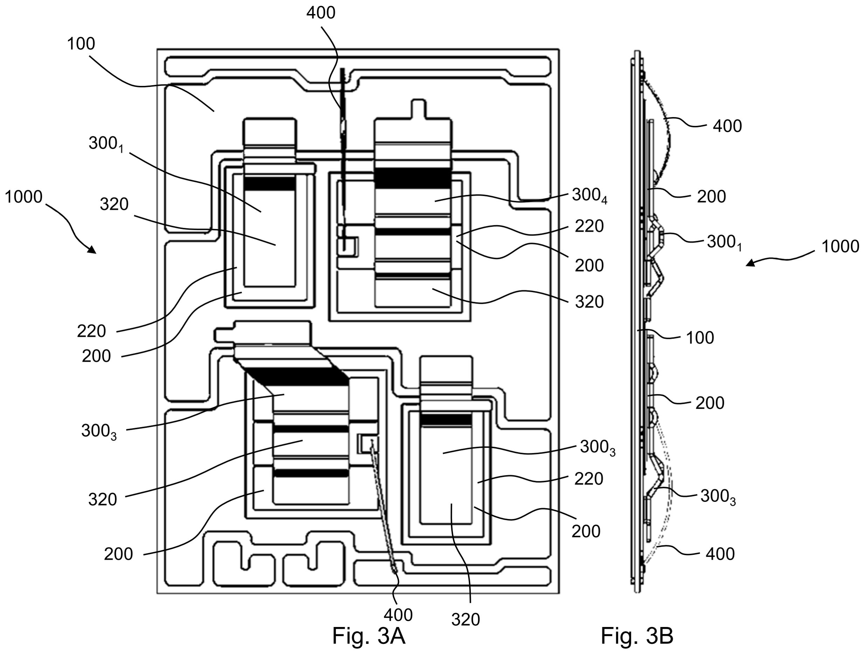

Fig. 3A shows the implementation of four heat transfer components 300₁, 300₂, 300₃, and 300₄ on a semiconductor device 1000 and Fig. 3B shows the size view thereof.

The semiconductor device 1000 of Figs. 3A-3B comprises a substrate 100, four semiconductor dies 200 having a first die surface 210 and a second die surface 220 opposite to the first die surface 210, wherein the four semiconductor dies 200 are mounted with their first die surface 210 on the substrate 100. The substrate 100 may be made of a material such as silicon or copper, but may also comprise an insulative coating. More particularly, as shown in Fig. 3A, the substrate 100 comprises terminal patches, which are conductive patches that are at the same voltage potential. For the standard working of a semiconductor die acting as a transistor, there are at least three such patches. A first acts as a source, being at a particular voltage potential, the other patch acts as a drain, being at a different voltage potential. By means of the gate, being located on yet another patch, the current between the source and the drain can be controlled. These patches are part of the substrate 100 and might be etched into the substrate 100 or may be deposited thereon. More importantly, the heat transfer components 300₁, 300₂, 300₃, and 300₄, are mounted to specific patches or locations on the substrate, such that they obtain the functionality required by the semiconductor device 1000.

Further, the semiconductor device 1000 comprises the four already-mentioned heat transfer components 300₁, 300₂, 300₃, and 300₄ comprising a spatial configuration composed of a first component face 310 and a second component face 320 spaced apart from each other defining a spatial enclosure 350 comprising a heat transfer medium 390 (not shown), wherein the at least one heat transfer component 300₁, 300₂, 300₃, and 300₄ is in heat exchanging contact with the second die surface 220 and the substrate 100. In Fig. 3A only the second component face 320 of the heat transfer component 300₁, 300₂, 300₃, and 300₄ is visible.

The shown semiconductor device 1000 is not only able to transfer heat away from the semiconductor die 200 by means of the heat transfer component 300₁, 300₂, 300₃, and 300₄, but can also effectively transfer current from and to the semiconductor die 200. Thereby, the semiconductor has an improved thermal management, but does not become bulky with additional heatsinks or cooling elements, such that the original size of the semiconductor device 1000 can be maintained.

All four heat transfer components 300₁, 300₂, 300₃, and 300₄ are mounted to the second surface side 220 of a semiconductor die 200, as well as being mounted to the substrate 100. This way the same component face of the heat transfer component 300₁, 300₂, 300₃, and 300₄ is connected to both. Therefore, it may be understood that the porous condensing structure 360 preferably is positioned in the spatial enclosure 350 on the same component face. This way heat can be effectively removed from the second die surface 220 (top side of the semiconductor die 200) towards the substrate 100 of the semiconductor substrate 100.

Lastly, positioning an electrical and heat conductive heat transfer component 300₁, 300₂, 300₃, and 300₄ on top of a semiconductor die 200, being connected to the substrate 100 as well, ensures that the heat transfer component can act as a bond clip having improved thermal performance over standardized bond clips, but also allowing for higher current carrying capacity due to the increased (contact)size. This all leads to an improved reliability of the semiconductor device.

In Fig. 3A two bond wires 400 are shown as well, which are connected from the substrate 100 to the gate of a semiconductor die 200. The parts that each component on the substrate 100 is connected too may be electrically isolated, which are known as terminals. This way, specific functionality of the semiconductor device 1000 can be invoked by powering specific combinations or sequences of terminals.

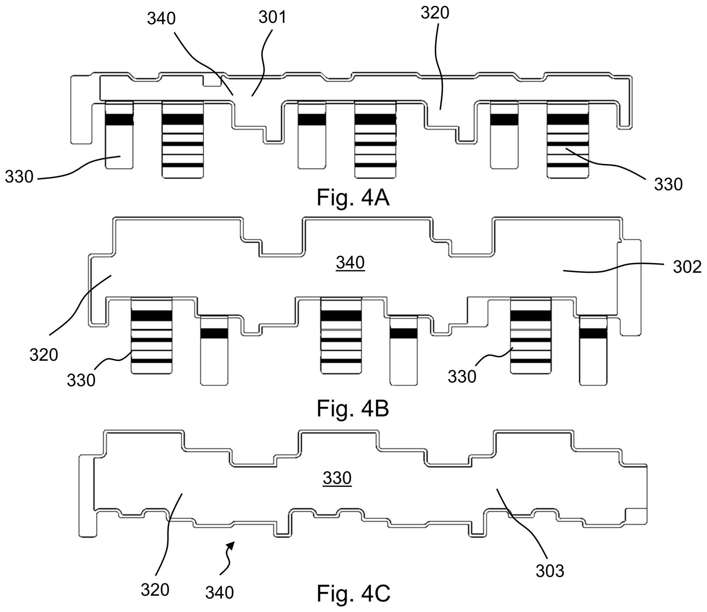

Yet different heat transfer components 301, 302, and 303 are shown in the Figs. 4A-4C. These heat transfer components 301, 302, and 303 comprises a spatial configuration composed of a first component face 310 and a second component face 320 spaced apart from each other defining a spatial enclosure 350 comprising a heat transfer medium 390, wherein the at least one heat transfer component 301, 302, and 303 is in heat exchanging contact with a heat source 500, similar to the previously discussed heat transfer components 301, 302, and 303. However, the heat transfer components 301 and 302 from Figs. 4A-4B have a more complex three dimensional structure. Namely, they comprise multiple protrusions adapted to mount to a second die surface 220 of a semiconductor die 200. Additionally, the heat transfer components 302 and 303 of Figs. 4B-4C comprise mounting regions adapted to mount a semiconductor die 200 with its first die surface 210 in such a manner that the heat transfer component 302 and 303 is positioned in between the semiconductor die 200 and the substrate 100. These heat transfer components 302 and 303 are then in heat exchanging contact as well as electrical contact with both the substrate 100 and the first die surface 210 of the semiconductor die 200. In other words these heat transfer components 302 and 303 are supported by the substrate 100 and in turn support the at least one semiconductor die 200.

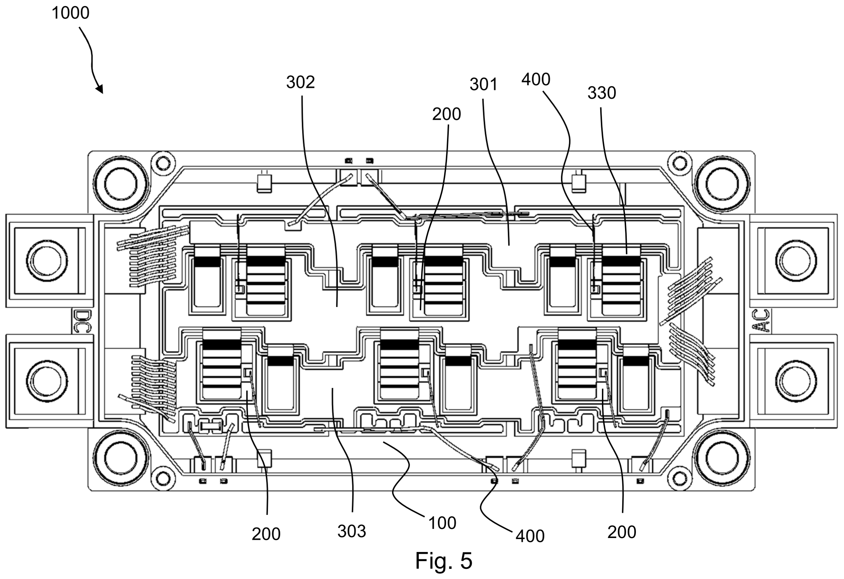

The semiconductor device 1000 comprising all three heat transfer components 301, 302, and 303 of Figs. 4A-4C is shown in Fig. 5. When we look at the stacking of this semiconductor device 1000, we would start with the substrate 100 at the bottom, then mount the heat transfer component 303 of Fig 4C, subsequently three further semiconductor dies 200 are positioned on the mounting regions of the heat transfer component 303. Then the heat transfer component 303 of Fig. 4B would be mounted to both the substrate 100 and the second die surfaces 220 of each of the three further semiconductor die 200s. Then three semiconductor dies 200 are mounted to the mounting regions of the heat transfer component 302 of Fig. 4B. Lastly, the heat transfer component 301 of Fig. 4A is mounted to both the substrate 100 and the second die surface 220 of the three semiconductor die 200s. It should be noted, thus, that the heat transfer component 302 of Fig. 4B both transfers heat from the second component face 320 (from the semiconductor die 200 on top) as well as from the first component face 310 (from the further semiconductor die 200 on the heat transfer component 303 of Fig. 4C to the substrate 100.

The semiconductor device 1000 of Fig. 5 having a further heat transfer component 301, 302, and 303 allows to transport heat away from the semiconductor die 200 from both of its sides, thereby improving the heat management of the semiconductor device. Furthermore, this design allows to connect multiple semiconductor dies 200 in series, since the heat transfer component also transfers current.

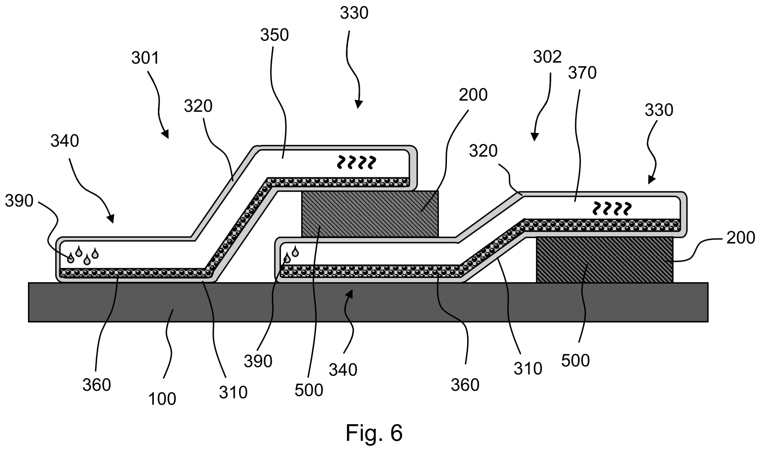

Fig. 6 shows a cross-sectional view of a similar configuration as described in Fig. 5, wherein the semiconductor device 1000 comprises a heat transfer component 301 mounted to the substrate 100 and to the second die surface 220 of a semiconductor die 200. The semiconductor die 200 is mounted to the substrate 100 by means of a further heat transfer component 302, which creates a thermal path between the first die surface 210 of the semiconductor die 200 and the substrate 100. That same further heat transfer 302 component is also mounted to the second die surface 220 of a further semiconductor die 200. The first die surface 210 of the further semiconductor die 200 is mounted directly to the substrate 100 in Fig. 6, but could also be connected by means of an even further heat transfer component, similar to Fig. 5.

With the configuration of Fig. 6 the semiconductor die 200 and the further semiconductor die 200 are electrically positioned in series. At the same time, the heat from the semiconductor die 200 is extracted efficiently from both the top (second die surface 220) as well as the bottom (first die surface 210). The heat from the further semiconductor die 200 is only transported via its top (second die surface 220) towards the substrate 100.

The expert will understand that the heat-transferring efficiency of the further heat transfer component 302 will be lower than the heat-transferring efficiency of the heat transfer component 301, since additional heat is introduced at the "cold" portion 340 because of the on top positioned semiconductor die 200. Nevertheless, it has been found that utilizing these heat transfer components 301 and 302 a better thermal management is achieved than with solid, monoblock bond clip.

Even though not explicitly mentioned, the expert in the field with understand that the heat transfer components 300 discussed in the figures may be fixedly connected to the substrate 100 and/or semiconductor die 200 by means of a solder, adhesive, or the like. These connecting means must then also have the same properties of conducting both heat as well as current. Only when connecting to the substrate 100 it may be beneficial to only have a thermal connecting and not an electrical connection. This, however, depends on the layout of the semiconductor device.

All in all, the semiconductor devices 1000 according to the disclosure with its working principle explained in the above-described figures has an improved heat management and allows for effective current transfer without increasing the bulkiness or size of the semiconductor device 1000 in general. Thereby improving the quality and reliability of the semiconductor devices without jeopardizing its layout or size requirements.

### LIST OF REFERENCE NUMERALS USED

- 1000: a semiconductor device
- 100: a substrate
- 200: at least a first semiconductor die
- 210: a first die surface
- 220: a second die surface
- 300: at least one heat transfer component
- 300₁-300₂-300₃ etc.: a primary, a secondary, a tertiary, etc. configuration of a heat transfer component
- 301: a first heat transfer component
- 302: a further heat transfer component
- 303: another further heat transfer component
- 310: a first component face 310
- 320: a second component face 320
- 330: a first portion 330
- 340: a second portion 340
- 350: a spatial enclosure 350
- 360: a porous condensing structure 360
- 370: a pillar 370
- 390: a heat transfer medium 390
- 400: a bond wire 400
- 500: heat source 500

## Claims

1. A semiconductor device comprising:
a substrate;
at least one first semiconductor die having a first die surface and a second die surface opposite to the first die surface, wherein the at least one semiconductor die is mounted with the first die surface on the substrate;
at least one heat transfer component comprising a spatial configuration composed of a first component face and a second component face spaced apart from each other defining a spatial enclosure comprising a heat transfer medium, wherein the at least one heat transfer component is in heat exchanging contact with the second die surface and the substrate.

2. The semiconductor device according to claim 1, further comprising a further heat transfer component, wherein the further heat transfer component is arranged between the substrate and the first die surface of the at least one semiconductor die, being in heat exchanging contact.

3. The semiconductor device according to claim 2, further comprising at least a further semiconductor die, wherein the further heat transfer component is in heat exchanging contact with the second die surface of the at least further semiconductor die.

4. The semiconductor device according to any of the preceding claims, wherein each heat transfer component further comprises a porous condensing structure contained in the spatial enclosure for the heat exchanging medium.

5. The semiconductor device according to claim 4, wherein the porous condensing structure is mounted to the first component face.

6. The semiconductor device according to claim 4 or 5, wherein each heat transfer component is made of a heat conductive and electrically conductive material.

7. The semiconductor device according to any of the preceding claims, wherein each heat transfer component has a planar shape, wherein a thickness of the planar shape is less than 0.5 mm, preferably less than 0.33mm, most preferably less than 0.21mm.

8. The semiconductor device according to any of the preceding claims, wherein each component face has a thickness of less than 100 µm, preferably less than less than 50 µm, more preferably less than 10 µm.
